# EUROPEAN PATENT SPECIFICATION

(11) **EP 2 699 068 B1**
(45) Date of publication and mention of the grant of the patent: **17.08.2016**
(21) Application number: 12771148.9
(22) Date of filing: 10.04.2012
(51) Int. Cl.: H05K 9/00

(54) **DEVICE FOR SCREENING A TOUCH-SENSITIVE MAGNETOCARDIOGRAPH UNIT**
VORRICHTUNG ZUM SCREENING EINER BERÜHRUNGSEMPFINDLICHEN MAGNETOKARDIOGRAPHENEINHEIT
DISPOSITIF DE PROTECTION D'UNITÉ DE DÉTECTION DE MAGNÉTOCARDIOGRAPHE

(30) Priority: 11.04.2011 UA 2011004435
(43) Date of publication of application: 19.02.2014
(73) Proprietor: Sosnytskyy, Volodymyr Mykolayovych, Kiev 02002 (UA); Sutkovyi, Pavlo Gnatovych, Kiev 04060 (UA)
(72) Inventor: Sosnytskyy, Volodymyr Mykolayovych, Kiev 02002 (UA); Sutkovyi, Pavlo Gnatovych, Kiev 04060 (UA)
(74) Representative: Forsythe, Dominic
(86) International application number: PCT/UA2012/000041
(87) International publication number: WO 2012/141670

(56) References cited:
- EP-A1- 2 099 277
- EP-A2- 0 632 688
- EP-A2- 1 515 149
- JP-A- 4 093 090
- RU-U1- 39 718
- US-A- 5 475 306
- US-A1- 2010 094 117

## Description

The invention relates to the field of technical means which protect highly sensitive measuring equipment from the effects of high-frequency external noise and can be used for shielding the magnetocardiographic systems operating in unshielded rooms.

Superconductive quantum interference detectors characterized by record-high sensitivity up to 10⁻³², J/Hz within wide band (0 to tens of GHz) are usually used as sensors in magnetocardiographs, while useful magnetic signal from the measured object is concentrated in a narrow low-frequency band (0.1-100 Hz). In the presence of interference from radio stations, mobile communication, electrostatic discharges and numerous other sources of electromagnetic radiation, stable functioning of sensor detectors which are part of the sensor unit can be troubled. The level of interference at which normal working capacity of the sensor unit still maintains, shall not exceed the value of the magnetic component - about 0.1 nT. Such low own barrier-proof value of superconducting quantum interference detectors requires additional passive shielding.

Materials of high electrical conductivity (Cu, Al, etc.) are used for construction of electromagnetic shields. When the external magnetic field changes, the induction fluxes covering the shielded volume appear within the screen walls. Magnetic field of those fluxes is directed opposite the external disturbed field and compensates it partially. However, application of high-conductive materials is significantly limited as far as increase of conductivity causes increase of noise current (Nyquist's noise) of the shield, which is perceived by a sensitive sensor as an external noise, while too low level (value) of the measured signals causes the need of control of all possible noise sources.

There are various ways to remove the impact of noises. The most radical way is shielding of a relatively large volume (room) and, thus, distancing of the shield walls far from the magnetic field sensors. Up to date, passive electromagnetic shields in the form of entirely shielded rooms (which can cost several times more than the magnetocardiographs themselves) are widely used to ensure efficiency of magnetocardiographic systems.

The need to use shielded room for biomagnetic research is formulated in the US Patent 5,152,288; Apparatus and method for measuring weak, location-dependent and time-dependent magnetic fields, Hoening E., Reichenberger H., Schneider S., G01R 35/00, G01R 33/035, October 6, 1992.

This patent is taken as a prototype. Sensor unit along with the other electronic units of magnetometer and patient positioning system are surrounded in the prototype device by an electromagnetic shield constructed of high-conductive materials.

Structural elements of such shield should be sufficiently distanced from the sensors in order to limit the noise effect of the shield itself, and therefore the whole room, in which weak magnetic fields are measured, is shielded. The shielded room is an expensive construction, and only the largest scientific centers can afford it.

The invention is based on the task of creating the shielding device for the sensor unit of magnetocardiograph that would remove the excessive noises made by the shields, and that would be inexpensive.

The task in view is addressed as follows: *according to the invention*, electromagnetic shield of the shielding device for sensor unit of magnetocardiograph consists of a lower part - shield for shielding the detectors, and upper part - shielding cover for shielding the pre-amplification electronic units that is tightly fitted over the lower part; the shield lower part is performed on the supporting frame consisting of two tandem coaxial cylinders without bottoms, and a multilayer woven radar absorbent material on graphite basis is fastened to its external surface; bottom of the shield frame is covered by one layer of the woven radar absorbent material, the shielding cover on the frame is made as a plastic cylinder which is closed by the upper plane of the cylinder, and a multilayer woven radar absorbent material on graphite basis is fastened to its outer surface, and bars of copper foil are fixed to its bottom edge to provide electrical contact between the lower and upper parts of the electromagnetic shield. An opening which allows supply of cables to pre-amplification electronic units is made in the lateral surface of the upper part of electromagnetic shield.

Design of electromagnetic shield with multilayer woven radar absorbent materials based on graphite fibers, elements of which can be located in close proximity to the magneto-sensitive sensors, weaken the noise currents in the shield walls and, thus, remove excessive noise introduced to the shielded volume by the shield.

Use of only the sensor unit of magnetocardiograph in the prototype instead of the shielded rooms significantly reduces the cost of the construction.

The invention is explained by a drawing, which shows the shielding device for the sensor unit of magnetocardiograph.

The device includes an electromagnetic shield, consisting of a lower part (1) - shield for shielding the detectors, and the upper part (2) - shielding cover for shielding the pre-amplification electronic units, which is tightly fitted over the lower part (1). The shield lower part (1) is performed on the supporting frame (3), which consists of two tandem coaxial cylinders made of plastic with no bottom, and with a multilayer woven radar absorbent material on graphite basis (4) fastened to its external surface, and bottom of the shield frame is closed with one layer of woven radar absorbent material (5). The shield upper part (2) is performed on the frame (6) as a plastic cylinder closed by the upper plane and with a multilayer woven radar absorbent material (4) fastened to its external surface, and bars of copper foil (7) on the bottom edge to provide electrical contact between the lower (1) and upper (2) part of the electromagnetic shield. An opening (8) that allows supply of cables to pre-amplification electronic units is made in the lateral surface of the upper part (2).

Electromagnetic shield operates as follows.

Electromagnetic wave that is incident on the shield is partially reflected from the shield surface. As efficiency of reflection is proportional to conductivity of the shield material, insufficient reflection efficiency is compensated by increase of absorption of electromagnetic wave by increasing the thickness of the shield walls, and increase of shielding efficiency due to multiple internal reflection (and absorption) of waves from differently directed woven graphite fibers. At the same time relatively low conductivity of graphite and crossing poles between single fibers of the graphite fabric weaken the noise currents in the screen walls and, thus, remove excessive noise introduced by the screen itself to the shielded volume. Bars (7) of copper foil provide electrical contact between the lower (1) and upper (2) part of the electromagnetic shield, forming no closed circuit of high conductivity.

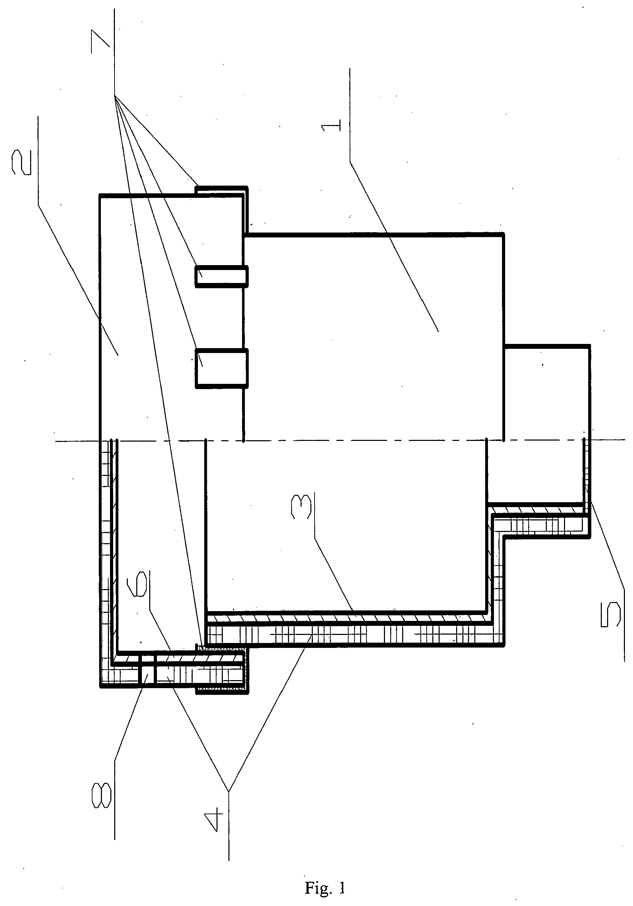

## Claims

1. Shielding device for the sensor unit of magnetocardiograph that contains electromagnetic shield, ***characterized in that*** the electromagnetic shield consists of the lower part - shield (1) for shielding the detectors and upper part - shielding cover (2) for shielding the pre-amplification electronic units, which is tightly fitted over the lower part; the shield lower part is performed on the supporting frame (3), which consists of two tandem coaxial cylinders without bottoms, and a multilayer woven radar absorbent material on the graphite basis (4) is fastened to its external surface; the frame bottom is closed by one layer of the woven radar absorbent material (5), shielding cover is performed on the frame as a plastic cylinder covered by the cylinder upper plane, and with a multilayer woven radar absorbent material on the graphite basis (4) fastened to its external surface, and bars of copper foil (7) on the bottom edge to provide electrical contact between the lower and upper part of the electromagnetic shield, and an opening (8) that allows supply of cables to the pre-amplification electronic units is made in the lateral surface of the upper part of the electromagnetic shield.

## Patentansprüche

1. Schutzvorrichtung für die Sensoreinheit eines Magnetokardiographs, welche einen elektromagnetischen Schutz enthält, **dadurch gekennzeichnet, dass** der elektromagnetische Schutz besteht aus dem Unterteil-Schutz (1), um die Detektoren zu schützen, und einer Oberteil-Schutzabdeckung (2), um die elektronischen Vorverstärkungs-Einheiten zu schützen, welche fest über dem Unterteil angebracht ist; wobei das Schutz-Unterteil auf dem Halterahmen (3) ausgeführt ist, welcher aus zwei Tandem-Koaxialzylindern ohne Böden besteht, und wobei ein mehrschichtiges gewebtes Radar-absorbierendes Material auf der Graphitbasis (4) an seiner Außenfläche befestigt ist; wobei der Rahmenboden durch eine Schicht des gewebten Radar-absorbierenden Materials (5) verschlossen ist, wobei die Schutzabdeckung auf dem Rahmen ausgeführt ist als ein Kunststoffzylinder, welcher durch die Zylinder-Oberebene abgedeckt ist, und mit einem mehrschichtigen gewebten Radar-absorbierenden Material auf der Graphitbasis (4), welches an seiner Außenfläche befestigt ist, und Streben einer Kupferfolie (7) auf dem Bodenrand, um einen elektrischen Kontakt zwischen dem Unter- und Oberteil des elektromagnetischen Schutzes bereitzustellen, und dass eine Öffnung (8), welche eine Zufuhr von Kabeln zu den elektronischen Vorverstärkungs-Einheiten ermöglicht, in der Seitenfläche des Oberteils des elektromagnetischen Schutzes ausgebildet ist.

## Revendications

1. Dispositif de blindage pour l'unité de détecteur d'un magnétocardiographe qui contient un blindage électromagnétique, **caractérisé en ce que** le blindage électromagnétique est constitué du blindage de partie inférieure (1) pour blinder les détecteurs et du recouvrement de blindage de partie supérieure (2) pour blinder les unités électroniques de préamplification, qui est étroitement ajusté au-dessus de la partie inférieure ; la partie inférieure du blindage est réalisée sur le cadre support (3) qui est constitué de deux cylindres coaxiaux en tandem sans fond, et un matériau d'absorption de radar tissé multicouche sur la base en graphite (4) est fixé sur sa surface externe ; le fond du cadre est fermé par une couche du matériau d'absorption de radar tissé (5), le recouvrement de blindage est réalisé sur le cadre sous la forme d'un cylindre en plastique recouvert par le plan supérieur du cylindre, et avec un matériau d'absorption de radar tissé multicouche sur la base en graphite (4) fixé sur sa surface externe, et de barres de feuille de cuivre (7) sur le bord inférieur pour réaliser un contact électrique entre les parties inférieure et supérieure du blindage électromagnétique, et une ouverture (8) qui permet de fournir des câbles aux unités électroniques de préamplification est ménagée dans la surface latérale de la partie supérieure du blindage électromagnétique.
